Europäisches Patentamt

European Patent Office

Office européen des brevets

(19)

(11) Publication number: 0 067 661
A1

## (12) EUROPEAN PATENT APPLICATION

(21) Application number: 82302987.1

(22) Date of filing: 09.06.82

(51) Int. Cl.³: **H 01 L 27/08**
H 01 L 27/06, H 01 L 21/82

(30) Priority: 15.06.81 JP 90936/81
15.06.81 JP 90937/81

(43) Date of publication of application:
22.12.82 Bulletin 82/51

(84) Designated Contracting States:
DE FR GB IT

(71) Applicant: TOKYO SHIBAURA DENKI KABUSHIKI
KAISHA
72, Horikawa-cho Saiwai-ku
Kawasaki-shi Kanagawa-ken 210(JP)

(72) Inventor: Iwasaki, Hiroshi
47-11, Kagawa Chigasaki-shi
Kanagawa-ken(JP)

(72) Inventor: Kanzaki, Koichi
4-205, Miyamaedaira-aberiya 2-10-1, Miyamaedaira
Takatsu-ku Kawasaki-shi(JP)

(74) Representative: Freed, Arthur Woolf et al,
MARKS & CLERK 57-60 Lincoln's Inn Fields
London WC2A 3LS(GB)

(54) Semiconductor device and method for manufacturing the same.

(57) A semiconductor device is provided which comprises a semiconductor substrate of a first conductivity type; first semiconductor regions of a second conductivity type selectively formed in the semiconductor substrate; a second semiconductor region of the first conductivity formed on the semiconductor substrate by epitaxial growth; third semiconductor regions of the second conductivity type which are formed in the second semiconductor region by impurity diffusion from the surface and which are connected to the first semiconductor regions from the above; a MOS transistor having a channel of the first conductivity type and formed in one of the third semiconductor regions; a MOS transistor having a channel of the second conductivity type and formed in the second semiconductor region; and a bipolar transistor formed in the other of the third semiconductor regions. The semiconductor device can be manufactured using a minimum number of steps and having a high packing density. The MOS transistors are complementary MOS transistors and do not substantially cause the latch up phenomenon.

F I G. 2A

F I G. 2B

F I G. 2C

F I G. 3A

./...

F I G. 3B

F I G. 3C

F I G. 3D

F I G. 3E

F I G. 3F

- 1 -

Semiconductor device and method
for manufacturing the same

The present invention relates to a semiconductor device and, more particularly, to an integrated circuit device having a bipolar transistor and complementary MOS transistors, and also relates to a method for manufacturing the same.

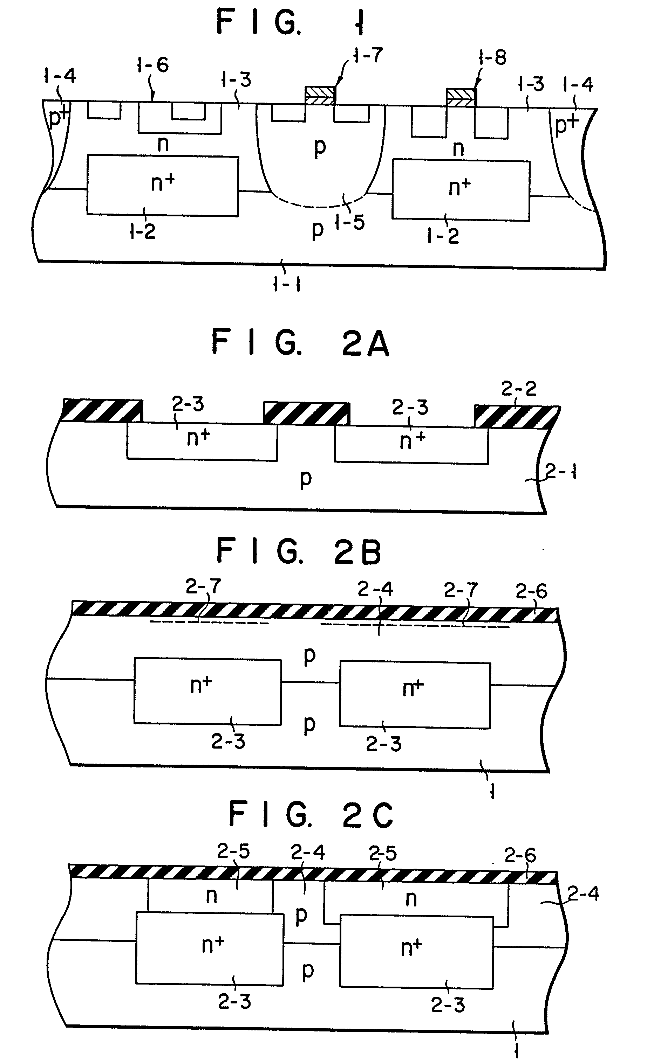

Fig. 1 shows a conventional semiconductor device in which complementary MOS transistors and a bipolar transistor are formed in a single semiconductor wafer. This conventional semiconductor device is manufactured by a method to be described below. First, a p-type silicon substrate 1-1 is prepared. An $n^+$-type buried layer 1-2 of high impurity concentration is selectively formed in the silicon substrate 1-1 by diffusion. An n-type epitaxial layer 1-3 is grown on the entire surface of the silicon substrate 1-1. A p-type well 1-5 and a p-type isolation region 1-4 for electrically isolating each circuit element are formed by thermal diffusion. The annealing time for forming the p-type well 1-5 is longer than that for forming the p-type isolation region 1-4. For this reason, the thermal diffusion process for forming the p-type well 1-5 is partially performed first. Subsequently, the remaining thermal diffusion process for forming the p-type well 1-5 is simultaneously performed with the thermal diffusion process for forming the p-type isolation region 1-4. According to the conventional method, a bipolar transistor 1-6 is formed in a region surrounded by the p-type well 1-5 and the p-type isolation region 1-4. A p-channel MOS transistor 1-8 which is one component of the complementary MOS transistors is formed in a region surrounded by the p-type well 1-5 and the p-type isolation region 1-4. An n-type channel MOS transistor 1-7 which is the other component of the complementary MOS transistors is formed in the p-type well 1-5.

However, with the conventional method as described above, the impurity in the $n^+$-type buried layer 1-2 diffuses into the n-type epitaxial layer 1-3 during the annealing process with high temperature and long time treatment for forming the p-type well 1-5 and the p-type isolation region 1-4. As a consequence, it is difficult to keep the impurity concentration of the n-type epitaxial layer 1-3 constant. However, the impurity concentration of the n-type epitaxial layer 1-3 must be kept constant since it is directly related to the static characteristics and the breakdown voltage of the transistor.

It is an object of the present invention to provide a semiconductor device which has excellent characteristics and which allows high integration, and to a method for manufacturing the same.

It is another object of the present invention to provide a semiconductor device which has complementary MOS transistors free from the latch up phenomenon.

It is still another object of the present invention to provide a semiconductor device which has complementary MOS transistors free from the latch up phenomenon and a bipolar transistor and which may be manufactured using a minimum number of steps.

In order to achieve the above and other objects according to the present invention, there is provided a semiconductor device comprising a semiconductor substrate of a first conductivity type; first semiconductor regions of a second conductivity type selectively formed in said semiconductor substrate; a second semiconductor region of the first conductivity formed on said semiconductor substrate; and third semiconductor regions of the second conductivity type which are formed in said second semiconductor region by impurity diffusion from the surface and which are connected to said first semiconductor regions from the above.

In the semiconductor device described above, a MOS transistor having a channel of the first conductivity type may be formed in the third semiconductor region, and a MOS transistor having a channel of the second conductivity type may be formed in the second semiconductor region. These two MOS transistors constitute the complementary MOS transistors. In addition to these MOS transistors, the bipolar transistor may be formed in another third semiconductor region.

The impurity concentration of the first semiconductor region is preferably greater than that of the third semiconductor region. The impurity concentration of the substrate is preferably equal to or greater than that of the second semiconductor region.

This invention can be more fully understood from the following detailed description when taken in conjunction with the accompanying drawings, in which:

Fig. 1 is a sectional view of a conventional semiconductor device;

Figs. 2A to 2C are sectional views showing an embodiment of a semiconductor device in the order of manufacturing steps; and

Figs. 3A to 3F are sectional views showing another embodiment of a semiconductor device in the order of the manufacturing steps.

The first embodiment of a semiconductor device of the present invention will be described according to the sequential manufacturing steps with reference to Figs. 2A to 2C.

Insulating films 2-2 such as thermal oxide films of a pattern for a mask for selective diffusion are formed on the surface of a p-type silicon substrate 2-1 having an impurity concentration of $10^{14}$ to $10^{17}$ cm$^{-3}$, as shown in Fig. 2A. An n-type impurity such as Sb or As is diffused into the substrate at a high temperature to form n$^+$-type buried layers 2-3 having a sheet resistance of 3 to 20 $\Omega/\square$ and a diffusion depth of 3 to 6 µm. In the next step shown in Fig. 2B, the insulating film 2-2 is completely removed to expose the surface of the substrate. A p-type epitaxial layer 2-4 is formed over the entire surface of the substrate. The impurity concentration and the thickness of the epitaxial layer 2-4 are generally $10^{14}$ to $10^{16}$ cm$^{-3}$ and 1 to 7 µm, although they vary depending upon the circuit element to be mounted. During the formation of the epitaxial layer 2-4, the impurity in the n$^+$-type buried layers 2-3 is partially diffused into the epitaxial layer 2-4 due to the autodoping effects. Consequently, as shown in Fig. 2C, n-type well regions 205 are formed within the epitaxial layer 2-4 and are connected to the n$^+$-type buried layers 2-3. These n-type well regions 2-5 are formed in the following manner. As shown in Fig. 2B, a thermal oxidation film 2-6 of about 1,000 Å thickness is formed on the surface of the epitaxial layer 2-4. Phosphorus is ion-implanted into the substrate through this film 2-6 to form a phosphorus diffusion source 2-7. The entire structure is annealed in an inert atmosphere at a high temperature to diffuse phosphorus, thereby forming the n-type well regions 2-5. During this annealing, the n-type impurity such as Sb or As is also diffused upward from the n$^+$-type buried layers 2-3, which facilitates formation of the n-type well regions
2-5.

In a semiconductor device of the structure as
shown in Fig. 2C, a p-type channel MOS transistor may
be formed in one of the n-type well regions 2-5, and
an n-type channel MOS transistor may be formed in the
portion of the p-type epitaxial layer 2-4 between this
n-type well region and the other n-type well region.
In addition to these complementary MOS transistors
formed in this manner, a bipolar transistor may be
formed in the other n-type well region 2-5.

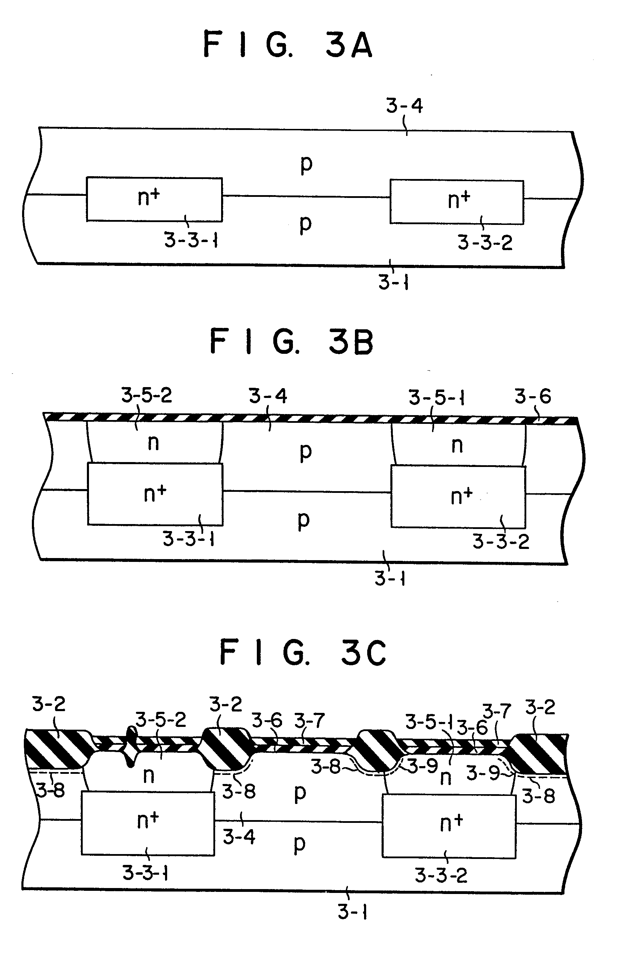

The second embodiment of the present invention
will now be described in sequential order of manufacturing steps with reference to Figs. 3A to 3F.
The second embodiment discloses a semiconductor device
in which both the complementary MOS transistors and
a bipolar transistor are formed within a single wafer.

As shown in Fig. 3A, an insulating film such as
a thermal oxidation film as a diffusion mask (not shown)
is formed on the surface of a p-type silicon substrate
3-1 having an impurity concentration of $10^{14}$ to
$10^{17}$ $cm^{-3}$. After patterning the thermal oxidation
film, Sb or As is diffused into the substrate to form
$n^{+}$-type buried layers 3-3-1 and 3-3-2 having an impurity
concentration of $10^{18}$ to $10^{20}$ $cm^{-3}$, for example. After
removing the thermal oxidation film, a p-type epitaxial
layer 3-4 is formed over the entire surface of the
substrate including the $n^{+}$-type buried layers 3-3-1,
3-3-2. The p-type epitaxial layer 3-4 has a sheet
resistance of 0.5 to 10 $\Omega/\square$ and a diffusion depth
of 1 to 5 μm. However, these are only examples to
help understand the invention and must be varied
according to the various types of the semiconductor
device to be formed within the epitaxial layer.

In the next step, as shown in Fig. 3B, n-type
well regions 3-5-1 and 3-5-2 are formed. In order to
form these n-type well regions, a thermal oxide film 3-6

is deposited to a thickness of about 1,000 Å on the surface of the wafer. Phosphorus is then ion-implanted to form a diffusion source.

The n-type well regions having an impurity concentration of 8 to 10 × $10^{15}$ $cm^{-3}$ may be formed by performing ion implantation at a dose of 2 × $10^{12}$ $cm^{-2}$ and an acceleration voltage of 150 keV, annealing, and diffusing to a depth of 3 μm. Annealing may be performed, for example, at 1,190°c. During the annealing process, n-type impurity such as Sb or As is also diffused upward from the n-type buried layers 3-3-1 and 3-3-2, causing the diffusion length from the above of the n-type well regions to be shortened. For this reason, the thermal diffusion time may be shortened to facilitate formation of the n-type well regions.

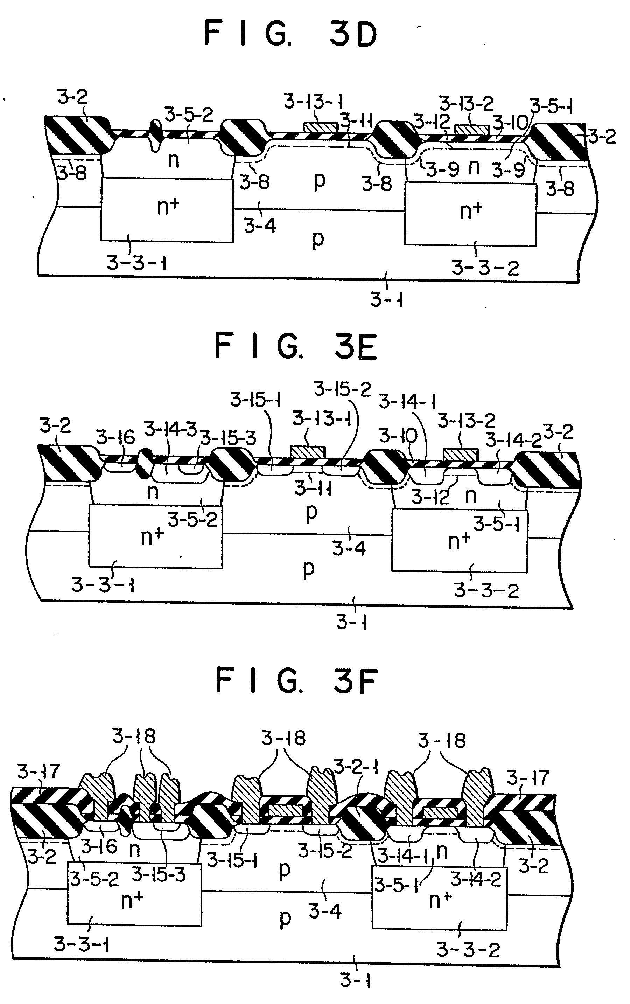

In the next step, as shown in Fig. 3C, an antioxidant insulating film such as a silicon nitride film 3-7 is deposited to a thickness of about 1,000 Å on the surface of the thermal oxidation film 3-6. The silicon nitride film 3-7 is patterned to allow formation of field oxide films 3-2. The field oxide films 3-2 are formed to a thickness of about 1 μm after formation of channel-cut regions 3-8 and 3-9 for parasitic field MOS transistor by ion implantation of boron and phosphorus. Alternatively, the field oxide films 3-2 may be replaced by buried insulating films into the wafer. Then, as shown in Fig. 3D, the silicon nitride film 3-7 and the underlying thermal oxide film 3-6 are removed. A gate oxide film 3-10 is formed on the exposed surface part of the wafer. Then, channel implantation regions 3-11 and 3-12 for controlling the threshold voltage of the n- and p-channel MOS transistors are formed, if necessary, in the n- and p-channel regions by combing both ion implantations of boron and phosphorus.

In the next step, as shown in Fig. 3E, a source region 3-14-1 and a drain region 3-14-2 of the p-channel MOS transistor are formed by ion implantation of boron using a resist film (not shown) as a mask. In this step are also formed a base region 3-14-3 of the bipolar vertical npn transistor; the emitter and the collector of the lateral pnp transistor (not shown); and a diffusion type resistor (not shown). The base region 3-14-3 may be formed in a separate ion implantation step to obtain the necessary bipolar transistor characteristics. The base region 3-14-3 of the draft type wherein the base region immediately below the emitter only is low in impurity concentration may be formed for the bipolar vertical npn transistor by suitably performing the ion implantation steps. It is desirable to form the external base region (high impurity base region) of the draft type base structure by ion implantation of boron simultaneously with the forming of the source region 3-14-1 and the drain region 3-14-2 of the P-channel MOS transistor. Various ion implantation steps may be selectively adopted, and heat treatment steps may be added as needed. In general, ion implantation of boron is preferably performed by adjusting the dose of the impurity and the acceleration voltage, so that annealing suffices. Subsequently, the following diffusion regions are formed which are necessary for an integrated circuit device: a source region 3-15-1 and a drain region 3-15-2 of the n-channel complementary MOS transistor; an emitter diffusion region 3-15-3 and a collector contact diffusion region 3-16 of the vertical npn transistor; and a base contact diffusion region of the lateral pnp transistor (not shown). These diffusion regions are preferably formed by ion implantation of arsenic using a resist film as a mask. It is convenient in some cases in terms of diffusion concentration and profile to form the $n^{+}$ implantation region after removal of the thermal oxidation film 3-10.

Finally, as shown in Fig. 3F, an oxide film 3-17 acting as a passivation film (CVD and PSG) is deposited, and gettering is performed according to the conventional method. After contact holes are formed and deposition and patterning of metal are performed, electrodes 3-18 for connection with the respective circuit elements are formed to complete the integrated circuit device.

In the semiconductor device of the structure as described above, the n-type well regions 3-5-1 and 3-5-2 located above the $n^+$-type buried layers 3-3-1 and 3-3-2 are formed in a short period of time due to the upward diffusion of the n-type impurity from the underlying $n^+$-type buried layers as well as due to the diffusion of n-type impurity from the above. The n-type well regions mentioned are electrically separated from each other in a self-alignment by the p-type epitaxial layer 3-4 and the p-type substrate 3-1; namely, the n-type well regions 3-5-1 and 3-5-2 electrically separated from each other in a self-alignment are formed within the silicon wafer. As a result, the p-channel MOS transistor is formed in the n-type well region 3-5-1, the n-channel MOS transistor is formed in the p-type epitaxial layer 3-4, and the bipolar npn transistor is formed within the n-type well region 3-5-2.

According to the present invention, the respective circuit elements may be formed in electrical isolation from each other due to the self-alignment formation of the n-type well regions 3-5-1 and 3-5-2, without requiring the formation of the p-type isolation region 1-4 and the deep p-type well 1-5 penetrating through the epitaxial layer 1-3 as in the conventional semiconductor device as shown in Fig. 1. Accordingly, complementary MOS transistors and a bipolar transistor may be formed within a single wafer with a reduced number of manufacturing steps and a reduced time. Furthermore, the $n^+$-type buried layer 3-3-2 directly below the n-type well region 3-5-1 in which the p-channel MOS transistor is formed serves to reduce by three digits the current amplification factor (hFE) of the parasitic vertical pnp transistor which may be formed by the source region 3-14-1 acting as an emitter, the $n^+$ buried layer 3-3-2 and the n-type well region 3-5-1, which regions act as a base, the p-type substrate 3-1 acting as a collector or formed by the drain region 3-14-2 acting as an emitter, the $n^+$ buried layer 3-3-2, and the n-type well region 3-5-1, which regions act as a base, and p-type substrate 3-1 acting as a collector. The $n^+$-type buried layers also serve to reduce the resistance of the n-type well region 3-5-1 from two digits to three digits. The resistance of the semiconductor substrate which depends upon the potential of the substrate comprising an n-channel MOS transistor and bipolar transistor may be reduced by increasing the impurity concentration therein. The reductions in the current amplification factor, in the resistance of the n-type well region and in the substrate resistance are highly effective for suppressing or eliminating the latch up phenomenon which is the greatest cause of the unsatisfactory operation of the complementary MOS transistor. For minimizing the influence of the latch up phenomenon, it was customary in the past to provide a sufficient distance between the p- and n-channel MOS transistors, e.g., to increase the length of the oxide film 3-2-1 in Fig. 3F, leading to a low integration density of the integrated circuit comprising CMOS transistors. However, the present invention permits suppressing the latch up phenomenon without providing a large distance between adjacent active elements, e.g., without increasing the length of the field oxide film 3-2-1, leading to an increased integration density of the integrated circuit.

In the semiconductor device shown in Fig. 3F, in order to reduce the collector resistance for the purpose of reducing the ON resistance of the vertical npn transistor formed in the n-type well region 3-5-2, a deep $n^+$-type diffusion connection layer (not shown) is preferably formed to connect the collector contact diffusion region 3-16 with the $n^+$-type buried layer 3-3-1. Such an $n^+$-type diffusion connection layer may also be formed within the n-type well region 3-5-1 in which the p-channel MOS transistor is formed so as to connect the $n^+$-type buried layer 3-3-2 with the suitable surface portion of the p-channel MOS transistor region. If such an $n^+$-type diffusion connection layer is formed, the resistance of the n-type well region 3-5-1 may be further reduced, and the latch up phenomenon of the complementary MOS transistors may be prevented with higher reliability. Formation of such an $n^+$-type diffusion connecting layer of high impurity concentration is preferably performed utilizing the thermal diffusing step for forming the n-type well regions 3-5-1 and 3-5-2. For example, after performing thermal diffusion of an impurity for forming the n-type well regions for a given period of time, a diffusion source for forming the $n^+$-type diffusion connecting layer is formed by ion implantation of phosphorus or deposition and formation of a P-As doped silicon glass layer. The n-type impurity is diffused from this diffusion source in the thermal diffusion for completing the formation of the n-type well regions. The $n^+$-type diffusion connecting layer is formed in this manner.

- 1 -

0067661

Claims:

1.  A semiconductor device comprising:

a semiconductor substrate of a first conductivity type;

first semiconductor regions of a second conductivity type selectively formed in said semiconductor substrate; a second semiconductor region of the first conductivity formed on said semiconductor substrate; and third semiconductor regions of the second conductivity type which are formed in said second semiconductor region by impurity diffusion from the surface and which are connected to said first semiconductor regions from the above.

2.  A semiconductor device comprising:

a semiconductor substrate of a first conductivity type;

first semiconductor regions of a second conductivity type selectively formed in said semiconductor substrate; a second semiconductor region of the first conductivity formed on said semiconductor substrate; third semiconductor regions of the second conductivity type which are formed in said second semiconductor region by impurity diffusion from the surface and which are connected to said first semiconductor region from the above; a MOS transistor having a channel of the first conductivity type and formed in one of said third semiconductor regions; and a MOS transistor having a channel of the second conductivity type and formed in said second semiconductor region.

3.  A semiconductor device comprising:

a semiconductor substrate of a first conductivity type;

first semiconductor regions of a second conductivity type selectively formed in said semiconductor substrate;

a second semiconductor region of the first conductivity formed on said semiconductor substrate;

third semiconductor regions of the second conductivity type which are formed in said second semiconductor region by impurity diffusion from the surface and which are connected to said first semiconductor regions from the above;

a MOS transistor having a channel of the first conductivity type and formed in one of said third semiconductor regions;

a MOS transistor having a channel of the second conductivity type and formed in said second semiconductor region; and

a bipolar transistor formed in the other of said third semiconductor regions.

4. A semiconductor device according to any one of claims 1 to 3, wherein an impurity concentration of said semiconductor substrate is equal to or greater than an impurity concentration of said second semiconductor region.

5. A semiconductor device according to any one of claims 1 to 4, wherein an impurity concentration of said first semiconductor regions is greater than an impurity concentration of said third semiconductor regions.

6. A method for manufacturing a semiconductor device, comprising:

selectively forming, in a semiconductor substrate of a first conductivity type, first semiconductor regions of a second conductivity type;

epitaxially growing a second semiconductor region of the first conductivity type on said semiconductor substrate; and

forming third semiconductor regions of the second conductivity type in said second semiconductor region by impurity diffusion from the surface, said third semiconductor regions being connected to said first

**0067661**

semiconductor regions from the above.

7.  A method for manufacturing a semiconductor device according to claim 6, further comprising:

forming a MOS transistor having a channel of the first conductivity type in one of said third semiconductor region; and

forming a MOS transistor having a channel of the second conductivity type in said second semiconductor region.

8.  A method for manufacturing a semiconductor device according to claim 7, further comprising:

forming a bipolar transistor in the other of said third semiconductor regions.

# FIG. 1

# FIG. 2A

# FIG. 2B

# FIG. 2C

# F I G. 3A

3-4

p

n+   n+

3-3-1   3-3-2

p

3-1

# F I G. 3B

3-5-2   3-4   3-5-1   3-6

n   p   n

n+   n+

3-3-1   3-3-2

p

3-1

# F I G. 3C

3-2   3-2   3-6  3-7   3-5-1 3-6  3-7  3-2

3-5-2

n   3-8   n   3-9   3-9

3-8   p   3-8   3-8

n+   3-4   n+

3-3-1   p   3-3-2

3-1

# F I G. 3D

# F I G. 3E

# F I G. 3F

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-3 920 484  (HITACHI LTD) *Claims 1-5; column 3, lines 5-31; column 4, lines 6-41; figures 1-8* | 1-8 | H 01 L  27/08 H 01 L  27/06 H 01 L  21/82 |
| X | IBM TECHNICAL DISCLOSURE BULLETIN, vol. 16, no. 8, January 1974, pages 2719-2720, New York (USA); P.P.CASTRUCCI  et  al.: "Bipolar/Fet  high-performance circuit". *Pages 2719-2720, text; page 2719; figures 1-3B* | 1-8 | |

TECHNICAL FIELDS SEARCHED (Int. Cl. ³)

H 01 L

The present search report has been drawn up for all claims

| Place of search | Date of completion of the search | Examiner |
|---|---|---|
| THE HAGUE | 22-09-1982 | FRANSEN L.J.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82